(19) Europäisches Patentamt
European Patent Office
Office européen des brevets

(11) **EP 2 147 330 B1**

(12) **EUROPEAN PATENT SPECIFICATION**

(45) Date of publication and mention
of the grant of the patent:
**08.11.2017 Bulletin 2017/45**

(51) Int Cl.:
*G01R 33/56* (2006.01)     *G01R 33/563* (2006.01)
*G06T 7/00* (2017.01)

(21) Application number: **08750503.8**

(22) Date of filing: **01.05.2008**

(86) International application number:
**PCT/GB2008/001533**

(87) International publication number:
**WO 2008/135738 (13.11.2008 Gazette 2008/46)**

(54) **IMAGE PROCESSING METHOD**

BILDVERARBEITUNGSVERFAHREN

PROCÉDÉ DE TRAITEMENT D'IMAGE

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **04.05.2007 GB 0708621**

(43) Date of publication of application:
**27.01.2010 Bulletin 2010/04**

(73) Proprietor: **BiOxyDyn Limited
Manchester
M13 9NT (GB)**

(72) Inventors:
• **EMBLETON, Karl, Vincent
Bollington
Macclesfield SK10 5RD (GB)**
• **PARKER, Geoffrey, James, Martin
Poynton
Cheshire SK12 1LE (GB)**
• **HAROON, Hamied, Ahmad
Manchester
Greater Manchester M15 6RP (GB)**

(74) Representative: **Robinson, David Edward
Ashdown et al
Marks & Clerk LLP
1 New York Street
Manchester M1 4HD (GB)**

(56) References cited:
• PARKER GEOFFREY J M ET AL: "Probabilistic anatomical connectivity derived from the microscopic persistent angular structure of cerebral tissue." PHILOSOPHICAL TRANSACTIONS OF THE ROYAL SOCIETY OF LONDON. SERIES B, BIOLOGICAL SCIENCES 29 MAY 2005, vol. 360, no. 1457, 29 May 2005 (2005-05-29), pages 893-902, XP007905313 ISSN: 0962-8436 cited in the application
• PARKER GEOFF J M ET AL: "Probabilistic Monte Carlo based mapping of cerebral connections utilising whole-brain crossing fibre information." INFORMATION PROCESSING IN MEDICAL IMAGING : PROCEEDINGS OF THE ... CONFERENCE JUL 2003, vol. 18, July 2003 (2003-07), pages 684-695, XP007905314 ISSN: 1011-2499 cited in the application
• PARKER GEOFFREY J M ET AL: "A framework for a streamline-based probabilistic index of connectivity (PICo) using a structural interpretation of MRI diffusion measurements." JOURNAL OF MAGNETIC RESONANCE IMAGING : JMRI AUG 2003, vol. 18, no. 2, August 2003 (2003-08), pages 242-254, XP007905317 ISSN: 1053-1807 cited in the application
• TUCH D S: "Q-Ball imaging" MAGNETIC RESONANCE IN MEDICINE, ACADEMIC PRESS, DULUTH, MN, US, vol. 52, 1 January 2004 (2004-01-01), pages 1358-1372, XP002473670 ISSN: 0740-3194 cited in the application
• JONES D K: "Tractography Gone Wild: Probabilistic Tracking Using the Wild Bootstrap" PROCEEDINGS OF ISMRM,, 1 January 2006 (2006-01-01), page 435, XP009103631

**(Cont. next page)**

EP 2 147 330 B1

- **HAROON H. A. AND PARKER G. J.: "Using the Wild Bootstrap to Quantify Uncertainty in Fibre Orientation from Q-Ball Analysis" PROC. ISMRM-ESMRMB JOINT ANNUAL MEETING, 19 May 2007 (2007-05-19), XP009103779 Berlin, Germany**

**Description**

The present invention relates to an image processing method and more particularly to a method for generating data indicating a degree of connectivity for each of a plurality of image elements, each image element representing a part of a body to be imaged. The invention has particular, although not exclusive, applicability in imaging of the human nervous system and in imaging of the nervous system of non-human animals.

A wide variety of imaging techniques are known in the art. One such technique is magnetic resonance imaging which is based upon nuclear magnetic resonance and which generates images of a body (for example a human body) based upon water content at each of a plurality of volume elements in the body.

Nuclear magnetic resonance (NMR) involves applying a magnetic field that acts on the nuclei of atoms with fractional spin quantum numbers and thereby polarizes them. During measurements, radio-frequency pulses of given resonance energy are applied that flip the nuclear spins and disturb the orientation distribution. The nuclei then return (relax) to the initial state in a time dependent exponential fashion and thereby provide a signal that may be electronically processed into recordable data. When the signals are spatially differentiated and of sufficient level, the data can be used to generate images suitable for display on a display screen. For example, computing the signals generated by the protons of water molecules within organic tissues makes it possible to construct magnetic resonance images (MRI) allowing direct visualization of internal organs in living beings. NMR is therefore a powerful tool in diagnostics, medical treatment and surgery.

Magnetic resonance imaging may also be used to measure the extent and orientation of passive self-diffusion of water molecules in a body. In general terms (i.e. when in their pure liquid state and unhindered by physical barriers) water molecules will diffuse equally in all directions (a process also known as Brownian motion). However, within the human body, where coherently-arranged microstructural elements such as cell membranes exist, there is likely to be a preferred orientation of diffusion. Such a preferred orientation of diffusion can be detected using magnetic resonance imaging techniques. In organs where the preferred orientation of diffusion observed in each image voxel is the result of long-range (with respect to the imaging spatial resolution) structural elements (hereafter referred to as 'biological pathways') it is possible to generate images that represent those biological pathways. The general class of MRI methods used to detect water self-diffusion in the body is known as diffusion weighted imaging (DWI). A number of variants of this technique are known, such as diffusion tensor imaging, diffusion spectrum imaging, and q-space imaging.

Imaging techniques intended to generate images representing biological pathways have particular applicability in brain imaging. Here, the biological pathways are the structures that interconnect brain regions, or other areas of a central nervous system. At the microscopic scale these are the axons associated with neuronal tissue. Axons are grouped together (particularly but not exclusively in the white matter) to form axonal bundles that provide the macroscopic diffusion signal generally exploited in such techniques. It is possible to generate images of areas of high microstructural orientation coherence, which tend to be concentrated in the white matter within a brain (where they may be referred to as 'fibre bundles'). Such white matter comprises fibre bundles which connect together various regions of grey matter within the brain. The grey matter makes up the brain's processing elements.

The orientational information concerning fibre bundle orientation that DWI provides may be exploited to analyse anatomical connectivity non-invasively via a process known as 'tractography' or 'fibre tracking'. A number of methods have been developed to infer connection between brain regions. These methods fall into two broad groups: 'deterministic' approaches and 'probabilistic' approaches. Probabilistic methods have the general advantage of being able to estimate the confidence with which an anatomical connection between any image voxel within a brain and another can be established from the DWI data.

Many techniques used to generate images representing the biological pathways have difficulty in accurately generating images in which a plurality of pathways cross one another at some point within the image. This often occurs in brain imaging. In such cases, such techniques do not accurately generate images properly showing each of the pathways. An example of such a technique is a fractional anisotropy technique described in Pierpaoli, C. and P. J. Basser: "Toward a quantitative assessment of diffusion anisotropy" Magnetic Resonance in Medicine 36, pp893-906.

One imaging technique is described in Parker, G.J.M and Alexander, D.C: "Probabilistic anatomical connectivity derived from the microscopic persistent angular structure of cerebral tissue", Phil. Trans. R. Soc. B (2005) 360, pp893-902. Here an image indicating connectivity between a particular starting point and other points within the body is generated and displayed. The described technique is based upon magnetic resonance imaging.

While many deterministic and probabilistic tractography techniques are effective, there is a general requirement to accurately locate or place starting points of interest. This can be very difficult if it is not known which areas of the brain are of interest, for example where it is not known where in the brain connections of interest exist. It is an object of embodiments of the present invention to obviate or mitigate at least some of the problems outlined above.

According to the present invention, there is provided, a method and apparatus for generating data indicating the degree of anatomical connectivity for each of a plurality of image elements as defined in the appended claims. Each image element represents a part of a body to be imaged. The method comprises, for each of a plurality of image elements, generating a data set indicating connections between that image element and others of said plurality of image elements. For each of said plurality of image elements, data indicating a degree of connectivity of that image element is generated. The degree of connectivity is based upon said plurality of generated data sets.

By generating a data set indicating connections between each of a plurality of image elements and other image elements, and then processing all image elements based upon the generated data sets, data indicative of the overall degree of connectivity of a particular point within the body being imaged can be generated. Methods provided by embodiments of the invention therefore allow the overall connectivity of a particular point within the body being imaged to be compared to the overall connectivity of other points within the body being imaged.

Each point within the body being imaged may be represented by a voxel. That is, the image elements may be voxels.

In the specific example of the brain, embodiments of the present invention allow the degree of anatomical connectivity from each brain voxel to every other brain voxel to be expressed to form a map of the degree of anatomical connectivity of each location of the brain parenchyma. Again, the methods provided allow information indicating connectivity of a particular voxel relative to other voxels to be generated.

Each of the data sets may represent a linear connection between one of said image elements and a plurality of other image elements.

The method may further comprise, for each of said plurality of image elements, generating a plurality of data sets. Each of said plurality of data sets may be a data set indicating connections between that image element and others of said plurality of image elements.

Each image element may have associated data indicating a plurality of possible connections for that image element, and said plurality of data sets may be based upon said data. The associated data may be a probability density function indicating probabilities of said possible connections. That is, for a particular image element the associated data may indicate probabilities for each of a plurality of image elements to which the particular image element may be connected.

Generating data indicating a degree of connectivity of an image element may comprise determining a number of data sets in which said image element is included. The method may further comprise generating image data based upon said data indicating a degree of connectivity. Each image element may be rendered using a value based upon said data indicating a degree of connectivity. Each image element may be rendered using a value based upon said data indicating a degree of connectivity relative to other image elements.

The image elements may be defined using data obtained from a magnetic resonance imaging technique. Each of the image elements may be defined using data indicative of an orientation of diffusion within said body at a point represented by that image element.

The method may further comprise deriving said probability density functions for each of said image elements based upon data indicative of said orientation of diffusion.

The body may be a human or animal body or a part of a human or animal body. For example, the body may be a human or animal brain or a part of a human or animal brain.

The method may further comprise comparing said image data with reference data to generate data indicating characteristics of said body. The reference data may be indicative of a clinically normal state of said body, and the comparison may generate data indicating whether said body is in a normal or diseased state. In this way, data generated using the methods described above can be used to detect differences in connectivity between a plurality of different bodies, for example between a plurality of different patients.

The method may further comprise comparing said image data with further data generated from said body at an earlier time. That is, first image data may be generated from a body at a first time and second image data may be generated from the same body at a second time. The first and second image data may be compared to generate data indicating a change in the state of the body. Such data may indicate development or degeneration of said body.

The present invention further provides a method and apparatus for generating data indicating likelihood of diffusion in each of a plurality of directions at an image element of an image representing a part of a body being imaged. The method comprises: generating a plurality of estimates of each of said plurality of directions of diffusion from said image data; and generating said data indicating likelihood of diffusion in each of said plurality of directions based upon said plurality of estimates.

The method may further comprise processing said image data by application of a Funk-Radon transform to generate transformed image data. The plurality of estimates of each of said plurality of directions of diffusion may be generated from said transformed image data.

Generating one of said plurality of estimates for each of said plurality of directions of diffusion may comprise sampling an orientation distribution function at each of a plurality of points. Each of said plurality of points may be located on the surface of a sphere.

Some of said plurality of estimates for each of said plurality of directions may be determined by generating a set comprising a plurality of points, processing said set of points with reference to a further set of points to generate difference data, and generating a new set of points based upon said difference data.

All aspects of the present invention can be implemented by way of methods and apparatus. Such apparatus can include suitably programmed computers as well as bespoke hardware. Aspects of the invention can be implemented by way of suitable computer programs, which can be embodied on both tangible and intangible carrier media.

Embodiments of the present invention will now be described, by way of example, with reference to the accompanying drawings in which:

Figure 1 is a schematic illustration of apparatus used to implement an embodiment of the present invention;

Figure 2 is a flow chart showing processing carried out in an embodiment of the invention at a high level;

Figure 3 is a schematic illustration of a subset of voxels;

Figure 4 is a flow chart showing how streamlines are generated representing connectivities between the voxels of Figure 3;

Figures 5A and 5B are flow charts showing a process for generating a probability density function for a voxel;

Figures 6A to 6C are images obtained using techniques in accordance with an embodiment of the invention;

Figures 7A to 7C are further images obtained using techniques in accordance with an embodiment of the invention;

Figures 8A to 8C are images obtained using a prior art imaging methodology;

Figures 9A to 9F are histograms showing voxel values taken from images obtained using techniques in accordance with an embodiment of the invention; and

Figures 10A to 10C are Bland-Altman plots indicating reproducibility of voxel values taken from images obtained using techniques in accordance with an embodiment of the invention, when such techniques are repeated.

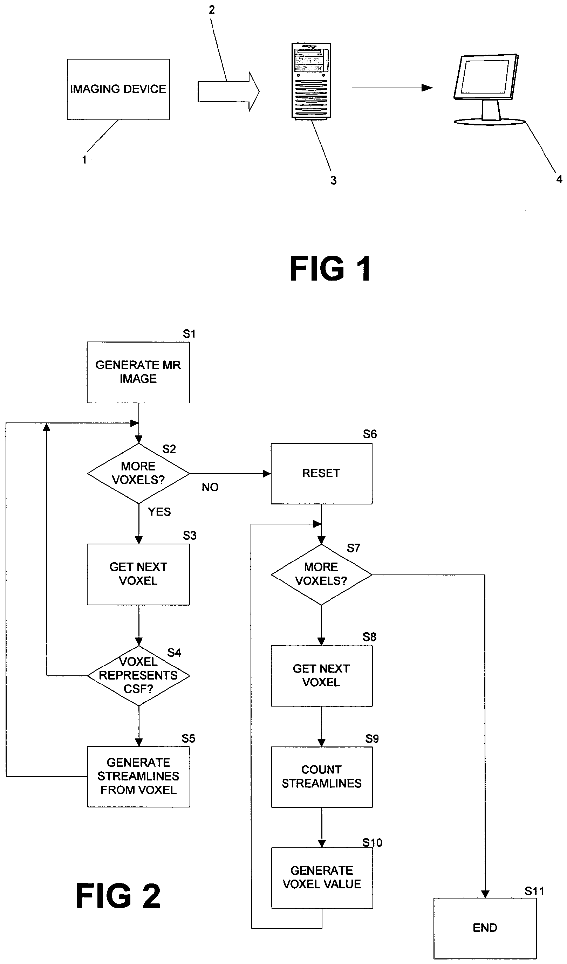

Referring first to Figure 1, it can be seen that an imaging device 1 outputs image data 2. The image data 2 is input to a PC 3 where it is further processed before being displayed on a display device 4. The PC 3 is configured to carry out various processing which is described in further detail below and which is intended to allow the generation of image data which is suitable for a particular purpose and which can be displayed on the display device 4.

In some embodiments of the invention image data representing an image of a human or animal brain is processed. In such embodiments the imaging device can take the form of a magnetic resonance imaging device, as is known in the art. In general terms such imaging devices generate image data based upon water content of a body which is imaged. Using a class of MRI methods known as diffusion weighted imaging DWI, data indicating the orientation of diffusion of water at a particular point of the body can be generated. For example, while in general terms water will diffuse equally in each possible direction, in a biological context, such as within the human brain, diffusion will be anisotropic, that is to say not equal in each possible direction. Such anisotropic diffusion can be caused by, for example, aligned microstructural elements within the body being imaged. In such a case magnetic resonance imaging techniques are able to determine tone or more dominant orientations of diffusion within an imaging voxel or the distribution of diffusion orientations within an imaging voxel, and thereby determine useful information relating to microstructural elements within a body being imaged.

Magnetic resonance imaging data generated by the imaging device 1 is input to the PC 3 where it is processed to generate useful information relating to characteristics of the body being imaged. This processing is shown at a high level in Figure 2. In general terms the processing is intended to define the degree of anatomical interconnection between voxels or regions of a brain. In general terms, higher levels of interconnection are expected in the white matter of the brain than in the grey matter of the brain. White matter is essentially parts of the brain which connect processing centres (within grey matter) together so as to allow communication.

Referring to Figure 2, it can be seen that at step S1 magnetic resonance image data is generated. Such data provides three-dimensional image data defined by a plurality of voxels. A voxel is a volume element, which has a similar function in three-dimensional imaging to that of a pixel in two-dimensional imaging.

Each voxel of the data generated at step S1 is processed in turn. At step S2 a check is carried out to determine whether further voxels remain to be processed. If the check of step S2 is satisfied, processing passes to step S3 where a voxel is selected for processing. At step S4 a check is carried to determine whether the voxel obtained at step S3 represents part of the cerebro-spinal fluid (CSF) within the brain. This processing can be carried out by a thresholding operation which is such that voxels having a value above or below the threshold (depending upon the imaging methodology) are determined to represent part of the cerebro-spinal fluid. Voxels that are determined to represent part of the cerebro-spinal fluid are processed no further, and processing therefore returns to step S2 where a check is carried out to determine whether further voxels remain to be processed.

Where a voxel is determined not to represent part of the cerebro-spinal fluid at step S4, processing continues at step S5. Here a plurality of streamlines are generated representing connections between the currently processed voxel and other voxels within the image data generated at step S1. The generation of streamlines is discussed in further detail below. It should however be noted that each streamline essentially represents a linear pathway between a currently processed voxel and a plurality of other voxels.

Having generated a plurality of streamlines at step S5, processing returns to step S2 and continues in the manner described above. It will be appreciated that iterations of steps S2 to S5 will generate a plurality of streamlines for each voxel of the image data generated at step S1 which is determined (at step S4) not to represent part of the cerebro-spinal fluid.

When the check of step S2 indicates that no further voxels remain to be processed, processing passes from step S2 to step S6. At step S6 a reset operation is carried out on a voxel counter, before processing passes to step S7 where a check is carried out to determine whether further voxels remain to be processed. If further voxels remain to be processed, processing continues at step S8 where a voxel is selected for processing. At step S9 a check is carried out to determine how many of the generated streamlines pass through the voxel selected at step S8. A value for the voxel being processed is then generated at step S10. Calculation of a value for the voxel being processed can be carried out according to equation (1):

$$\text{Voxel Value} = \frac{N}{M} \qquad\qquad (1)$$

Where:

N is the total number of streamlines, generated from each voxel, which pass through the voxel; and
M is the total number of generated streamlines.

It can be seen that by generating voxel values in accordance with equation (1) voxels through which a large number of streamlines pass have a higher value than voxels through which fewer streamlines pass. Using equation 1 it is therefore possible to produce an image in which voxel intensity (i.e. voxel value) is indicative of a number of streamlines passing through a particular voxel. That is, an image in which voxel intensity is indicative of the overall connectivity of a voxel can be generated.

Processing passes from step S10 to step S7 where a check is carried out to determine whether further voxels remain to be processed. If this is case, processing continues at step S8. Otherwise, processing terminates at step S11.

In an alternative embodiment, instead of applying processing as described with reference to steps S6 to S10 of Figure 2, the number of streamlines which pass through the voxel currently being considered may be determined by maintaining a running count of the number of times each voxel is intersected by a streamline during the processing of steps S2 to S5 above.

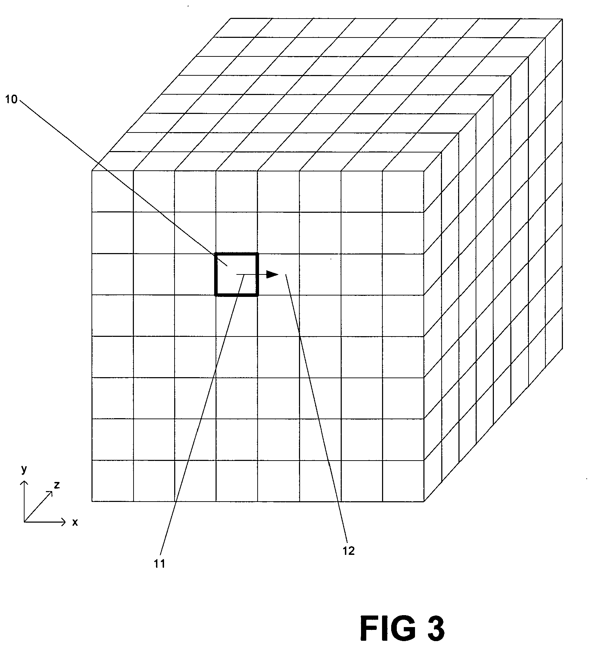

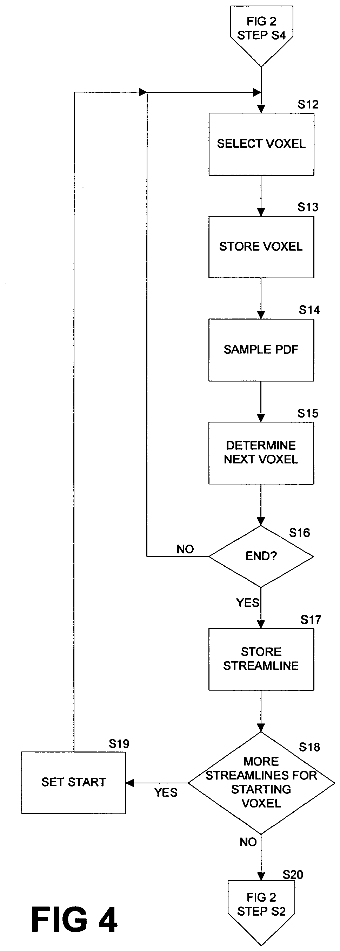

Referring back to step S5 of Figure 2, it can be seen that a plurality of streamlines for each voxel are generated. This processing is now described in further detail with reference to Figures 3 and 4, where Figure 3 is a schematic illustration of a relatively small number of adjacent voxels, and Figure 4 is a flow chart of processing carried out at step S5 of Figure 2.

Referring to Figure 3 it can be seen that a cuboid defined by a plurality of voxels is illustrated. For each voxel which does not represent cerebro-spinal fluid, a plurality of streamlines are generated. Each voxel in the cuboid of Figure 3 has an associated probability density function (PDF). The probability density function of a particular voxel represents the probability of diffusion in a variety of orientations in a part of the body represented by the voxel. The probability density function is generated using methods which are described in further detail below.

The number of streamlines generated starting from each voxel which does not represent cerebro-spinal fluid can be determined by requirements of the application for which image data is to be generated. It will be appreciated that, in general terms, a greater number of streamlines will provide higher quality data at a higher computational cost. In one implementation ten streamlines are generated for each voxel.

Referring to Figure 4 processing carried out to generate streamlines is described. At step S12 a voxel to be processed is selected, and data indicating the selected voxel is stored at step S13. The probability density function of the selected voxel is sampled at step S14 using a Monte-Carlo technique to provide an indication of diffusion direction at the selected voxel. This direction determines a next point in the volume of voxels which is to be processed. That is, referring to Figure 3, sampling the probability density function of a voxel 10 may generate direction data represented by the vector (1,0,0) as indicated by an arrow 11. In such a case a voxel 12 is selected for processing at step S 15.

The length of a vector selected at a particular voxel can be chosen in any convenient way. In general, smaller vector lengths (or 'step sizes') allow for more accurate imaging. When the length of the vector does not represent a step exactly from the centre of one voxel to a neighbour, a spatial data interpolation technique can be employed. Any suitable interpolation technique may be suitably employed. In a currently preferred embodiment of the invention, a trilinear interpolation technique is used. Such a technique is described in Parker, G. J. M., H. A. Haroon, et al.: "A framework for a streamline-based probabilistic index of connectivity (PICo) using a structural interpretation of MRI diffusion measurements" Journal of Magnetic Resonance Imaging 18, pp242-254.

In alternative embodiments of the invention, other interpolation methods are used. Such methods include 'nearest neighbour' interpolation as described in Mori, S., B. J. Crain, et al.: "Three-dimensional tracking of axonal projections in the brain by magnetic resonance imaging." Annals of Neurology 45, pp265-269; trilinear weighted sampling of the neighbourhood PDFs as described in Behrens, T. E. J., M. W. Woolrich, et al.: "Characterization and propagation of uncertainty in diffusion-weighted MR imaging" Magnetic Resonance in Medicine 50(5), pp1077-1088; and Runge-Kutta integration as described in Basser, P. J., S. Pajevic, et al.: "In vivo fiber tractography using DT-MRI data" Magnetic Resonance in Medicine 44, pp625-632.

In a currently preferred embodiment of the invention, each streamline is terminated when it encounters a voxel representing cerebro-spinal fluid. Voxels representing cerebro-spinal fluid can be detected in the manner described above. Other possibilities for streamline termination include terminating a streamline when curvature is beyond a user-defined threshold, terminating a streamline when the diffusion anisotropy within the voxel being traversed by a streamline is below a user-defined threshold, and terminating a streamline when the streamline exceeds a predetermined maximum length.

At step S16 a check is carried out to determine whether the processed streamline violates the chosen termination criteria. If this is not the case, processing continues at step S12 where the voxel determined at step S 15 is selected for processing.

If the check of step S16 determines that the currently generated streamline does not violate the chosen termination criteria, processing continues at step S17 where data indicative of the streamline is stored. Processing passes from step S17 to step S 18 where a check is carried out to determine whether further streamlines originating from a particular voxel (that voxel having been determined by step S3 of Figure 2) are to be generated. If this is the case, processing passes from step S18 to step S19 where the voxel determined at step S3 of Figure 2 is again selected, before processing continues in the manner described above at step S12.

When the check of step S18 determines that the predetermined number of streamlines originating at a particular voxel have been generated, processing passes from step S18 to step S20, from where processing returns to step S2 of Figure 2.

In the preceding description it has been explained that at each voxel a direction for a streamline which is being generated is determined by sampling of the probability density function using a Monte-Carlo technique. By repeated application of the method described above with reference to Figure 4 (i.e. by generating a plurality of streamlines), it will be appreciated that streamlines will indicate connectivities representative of the probability density functions associated with the voxels.

The generation of streamlines using probability density functions is described in Parker, G.J.M and Alexander, D.C: "Probabilistic anatomical connectivity derived from the microscopic persistent angular structure of cerebral tissue", Phil. Trans. R. Soc. B (2005) 360, pp893-902.

In alternative embodiments of the invention, alternative methods for the generation of streamlines using probability density functions are used. Examples can be found in Behrens, T. E. J., M. W. Woolrich, et al.: "Characterization and propagation of uncertainty in diffusion-weighted MR imaging", Magnetic Resonance in Medicine 50(5), pp1077-1088; Parker, G. J. M. and D. C. Alexander: "Probabilistic Monte Carlo based mapping of cerebral connections utilising whole-brain crossing fibre information", Lecture Notes in Computer Science 2732, pp684-695; Parker, G. J. M., H. A. Haroon, et al.: "A framework for a streamline-based probabilistic index of connectivity (PICo) using a structural interpretation of MRI diffusion measurements" Journal of Magnetic Resonance Imaging 18, pp242-254; Hosey, T., G. Williams, et al.: "Inference of multiple fiber orientations in high angular resolution diffusion imaging" Magnetic Resonance in Medicine 54, pp1480-1489; and Parker, G. J. M. and D. C. Alexander: "Probabilistic anatomical connectivity derived from the microscopic persistent angular structure of cerebral tissue" Philosophical Transactions of the Royal Society Series B 360, pp893-902.

The methods described above are not limited to using streamline methods for performing probabilistic tractography. That is, probabilistic tractography techniques can be applied in other ways. Alternatives include, for example, particle diffusion or particle jump methods, as described in Batchelor, P. G., D. L. G. Hill, et al.: "Study of connectivity in the brain using the full diffusion tensor from MRI" Proceedings of Information Processing in Medical Imaging IPMI'01, Davis, California, Springer-Verlag and Koch, M., V. Glauche, et al.: "Estimation of anatomical connectivity from diffusion tensor data" Neuroimage 13(6): S176-S176; and Koch, M. A., D. G. Norris, et al.: "An investigation of functional and anatomical connectivity using magnetic resonance imaging" Neuroimage 16, pp241-250. Alternatively, front evolution methods of the type described in Parker, G. J. M., C. A. M. Wheeler-Kingshott, et al.: "Estimating distributed anatomical brain connectivity using fast marching methods and diffusion tensor imaging" IEEE Transactions on Medical Imaging 21(5), pp505-512; and Tournier, J.-D., F. Calamante, et al.: "Diffusion-weighted magnetic resonance imaging fibre tracking using a front evolution algorithm" NeuroImage 20, pp276-288.

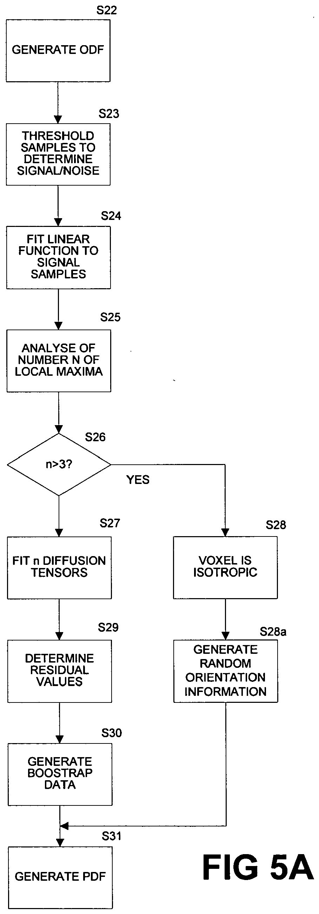

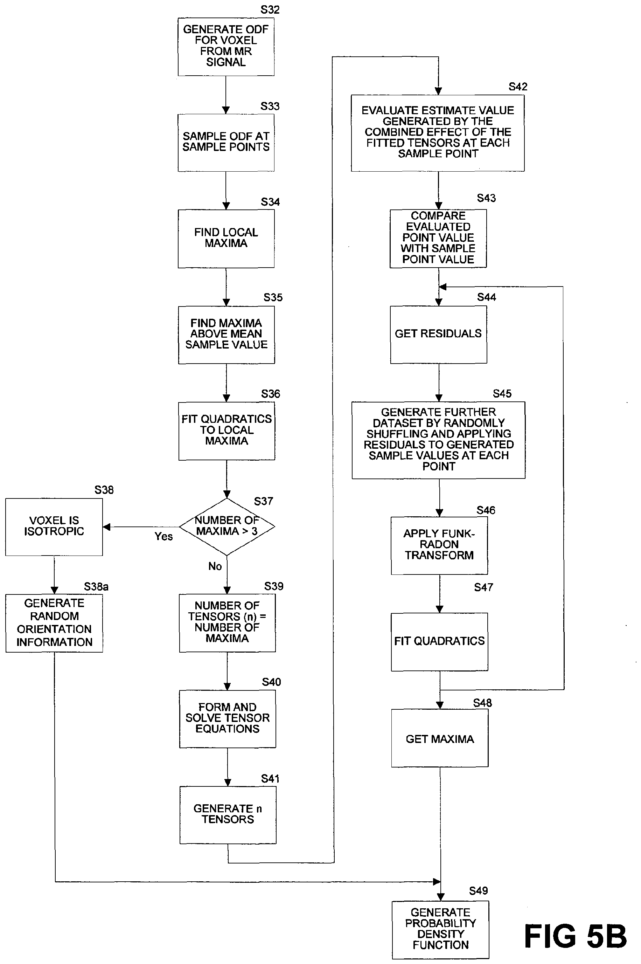

The processing described above is based upon a probability density function associated with each voxel. The generation of a probability density function for each voxel is now described in further detail. A process for generating a probability density function for a particular voxel is now described with reference to Figure 5A, and subsequently in further detail with reference to Figure 5B. In a preferred embodiment, diffusion orientation data for each voxel is generated by applying a Funk-Radon transform to Magnetic Resonance data as described in Tuch, David S.: "Q-Ball Imaging", Magnetic Resonance in Medicine (2004) 52, pp1358-1372.

A diffusion orientation distribution function (ODF) is generated for each voxel from the magnetic resonance data for that voxel at step S22 by application of the Funk-Radon transform as indicated above. The ODF is defined on the surface of a unit sphere centred at the centre of the voxel. In a preferred embodiment of the invention, sample values of the ODF are generated for each of a series of evenly distributed points on the unit sphere. In a preferred embodiment, the number of points is 642 and the configuration of the points on the surface of the sphere is given by the vertices of a three-fold tessellated icosahedron. Each sample value indicates measured diffusion information for the voxel along an axis defined by the path through the origin of the unit sphere and the point on the surface of the sphere denoted by the sample value.

At step S23, the sampled values are analysed in order to determine whether they are to be considered noise. In a preferred embodiment, the mean of the sampled values is calculated. Sampled values lower than the mean are considered to be noise samples, while sample values greater than the mean are considered to be signal samples, representative of diffusion directions for the voxel.

In steps S24 to S28, the sampled values are analysed in order to determine whether or not the voxel is anisotropic. In a preferred embodiment, a subset of the signal samples that have higher signal values than each of their immediate neighbours on the sphere (this can optionally be extended to define an arbitrarily large local neighbourhood if desired) are identified as local maxima and a linear function, for example a 2D quadratic function, is fitted to the subset of the signal samples in one hemisphere of the unit sphere for each voxel to find possible orientational diffusion maxima at step S24. The function is then analysed to determine the number of local maxima at step S25. If the number of local maxima is greater than a predefined threshold at step S26, the voxel is considered to be isotropic (i.e. to have no particular direction of diffusion) at step S28 and is associated with a random selection of orientations at step S28a. In a preferred embodiment, the threshold is 3.

If a voxel is considered anisotropic based upon the check of step S26, at step S27, the number and location of maxima in the signal values of the ODF for the voxel are used to determine the number of diffusion tensors for the application of a standard tensor mixture model as described in Tuch, D. S., T. G. Reese, et al.: "High angular resolution diffusion imaging reveals intravoxel white matter fiber heterogeneity" Magnetic Resonance in Medicine 48, pp577-582; and Parker, G. J. M. and D. C. Alexander: "Probabilistic Monte Carlo based mapping of cerebral connections utilising whole-brain crossing fibre information" Lecture Notes in Computer Science 2732, pp684-695. The tensor mixture model is then fitted to the magnetic resonance data for the voxel using a standard model fitting procedure such as Levenberg-Marquardt or simplex minimisation. The fitted tensor mixture model is used to generate a set of estimated values for the ODF sample values in the unit sphere. The difference between each estimated value and the sampled value for the same point on the unit sphere are recorded as residual values at step S29.

At step S30, a plurality of new datasets are generated based on the estimated values of the ODF and the residual values. First, a new dataset is generated by adding together each estimated value and a randomly selected residual value, and using the result as a new sampled value for the point on the unit sphere represented by the predicted values. The process is repeated in order to generate the plurality of data sets. This procedure is an implementation of a statistical technique known as 'model-based bootstrapping' or 'wild bootstrapping'.

At step S31, new estimates are made for the number and orientation of diffusion directions by the process of applying the Funk-Radon transform to the new data set and then by fitting a 2D quadratic function and finding local maxima, as described above in steps S22 to S25. When all of the data sets have been processed, the resulting estimates represent a probability density function for the voxel.

Having described the generation of a probability density function with reference to Figure 5A, the process is described in more detail with reference to Figure 5B. Processing is described with reference to a single voxel. It will however be appreciated that analogous processing is carried out for each voxel in turn.

At step S32 an ODF is generated from magnetic resonance data. At step S33 the generated ODF is sampled at a predetermined number of points (642 in the preferred embodiment as indicated above). Local maxima of the sampled points are determined in a convenient manner at step S34.

At step S35, the determined maxima are compared with a mean value for the sampled points. At step S36 maxima determined to have values above the mean are processed to fit a 2D quadratic function to each such maxima and its surrounding points. That is, each maxima having a value greater than the mean has an associated 2D quadratic function.

At step S37 the number of maxima having associated 2D quadratic functions is determined. If this number of maxima is greater than a predetermined limit, the voxel is determined at step S38 to be isotropic and random orientation information is associated with the voxel at step S38a. The PDF for this voxel is based upon the random orientation information. The predetermined limit can conveniently be three. If the number of maxima having associated 2D quadratic functions is not greater than the predetermined limit, processing passes to step S39 where a parameter $n$ indicating a number of tensors to be generated is set to be equal to the determined number of maxima having associated 2D quadratic functions. $n$ tensors are then generated at steps S40 and S41 as is now described.

Equation (2) is formed at step S40, and tensors are generated based upon the magnetic resonance data:

$$S(\mathbf{r}^i) =$$

$$S_0 \cdot \sum_{n=1}^{N} f_n \cdot \exp\left(-b \cdot \left[r_1^i r_1^i D_{1,1}^n + 2r_2^i r_1^i D_{2,1}^n + 2r_3^i r_1^i D_{3,1}^n + r_2^i r_2^i D_{2,2}^n + 2r_2^i r_3^i D_{2,3}^n + r_3^i r_3^i D_{3,3}^n\right]\right) \qquad (2)$$

where:

$S(\mathbf{r}^i)$ is the spin-echo diffusion-weighted signal obtained from the magnetric resonance data and measured along the gradient sampling direction $\mathbf{r}^i = \left\{r_1^i, \quad r_2^i, \quad r_3^i\right\}^{\mathrm{T}}$, where $i$ takes values from 1 to 61 in a preferred embodiment of the invention;

$$b = \gamma^2 \cdot \delta^2 \cdot G_0^{\,2} \cdot \left(\Delta - \left(\delta/3\right)\right),$$

where:

$\gamma$ is the gyromagnetic ratio for the proton;
$G_0$ is the maximum amplitude of the applied diffusion sensitisation gradients; and
$\delta$ is the duration of the applied diffusion sensitisation gradients, and $\Delta$ is the time interval between these gradients;

$S_0$ is a signal measured without any diffusion sensitisation (i.e. with $b = 0$);
$N$ is the number of fiber orientations estimated to exist in the voxel of interest, that is the number of tensors which are to be modelled; and

$f_n$ is the fractional contribution of each diffusion tensor $\underline{D}^n$ to $S(\mathbf{r}^i)$, such that $\sum_{n=1}^{N} f_n = 1$.

Each $\underline{D}^n$ is given by equation (3):

$$\underline{\mathbf{D}}^n = \begin{bmatrix} D_{1,1}^n & D_{1,2}^n & D_{1,3}^n \\ D_{2,1}^n & D_{2,2}^n & D_{2,3}^n \\ D_{3,1}^n & D_{3,2}^n & D_{3,3}^n \end{bmatrix} \qquad (3)$$

where $D_{2,1}^n = D_{1,2}^n$, $D_{3,1}^n = D_{1,3}^n$, $D_{2,3}^n = D_{3,2}^n$, as $\underline{D}^n$ is a symmetric positive definite tensor.

Equation (2) will be applied for each gradient sampling direction (61 in preferred embodiments), so as to produce a system of nonlinear equations. In general terms, it is to be noted that all parameters save for $\underline{D}^n$ and $f(n)$ are known, such that the generated equations can be used at step S41 to generate the desired tensors. Minimisation of the sum of squared differences between the acquired diffusion-weighted signal in the directions $\mathbf{r}^i$ and the predicted $S(\mathbf{r}^i)$ will give

the tensor elements of $\underline{\mathbf{D}}^n$.

For each of the points at which the original ODF was sampled at step S33, a value is generated based upon the generated tensors $\underline{\mathbf{D}}^n$ at step S42. In this way, the generated tensors provide a further set of points containing a number of points equal to that at which the ODF was sampled at step S33.

At step S43 the set of points generated at step S42 is processed together with the set of points sampled at step S33. This generates a set of error values at step S44. The generated error values are then applied to the set of points generated at step S42 so as to generate a further set of points at step S45. At step S46 a Funk-Radon transform is applied to the generated set of points, and at step S47 respective 2D quadratic equations are fitted to all maxima having a value above the mean value, as described above.

The processing of steps S44 to S47 is repeated a plurality of times so as to generate a plurality of sets of quadratic equations. The maximum of each 2D quadratic equation is taken at step S48 to represent an estimate of diffusion orientation. At step S49, processing is carried out to generate a probability density function from the generated quadratic equations.

The processing described above has been used to generate image data with good results. Magnetic resonance image data was obtained using a high angular resolution diffusion weighted imaging technique. This imaging used a dual direction k-space filling distortion corrected protocol as described in Embleton K.V., Lambon Ralph M.A. and Parker G. J.: "A combined distortion corrected protocol for Diffusion Weighted Tractography and fMRI", ISMRM, 1070, 2006. Imaging was carried out using a pulsed gradient spin echo EPI sequence on a 3T Philips Achieva scanner having an eight element SENSE head coil with a SENSE factor of 2.5. Phase encoding was in the left-right orientation. Imaging parameters were:

| | | |
|---|---|---|
| Echo time | TE | 54ms |
| Repetition time | TR | 11884ms |
| Gradient | G | $62\,mTm^{-1}$ |
| Matrix size | | 112x112 |
| Reconstructed resolution | | 1.875mm |
| Slice thickness | | 2.1mm |
| Number of slices | | 60 |
| Diffusion sensitation directions | | 61 |
| Sensitation | b | $1200\,smm^{-2}$ |
| Diffusion sensitisation gradient duration | $\delta$ | 13.5 ms |
| Diffusion sensitisation gradient spacing | $\Delta$ | 28.5 ms |

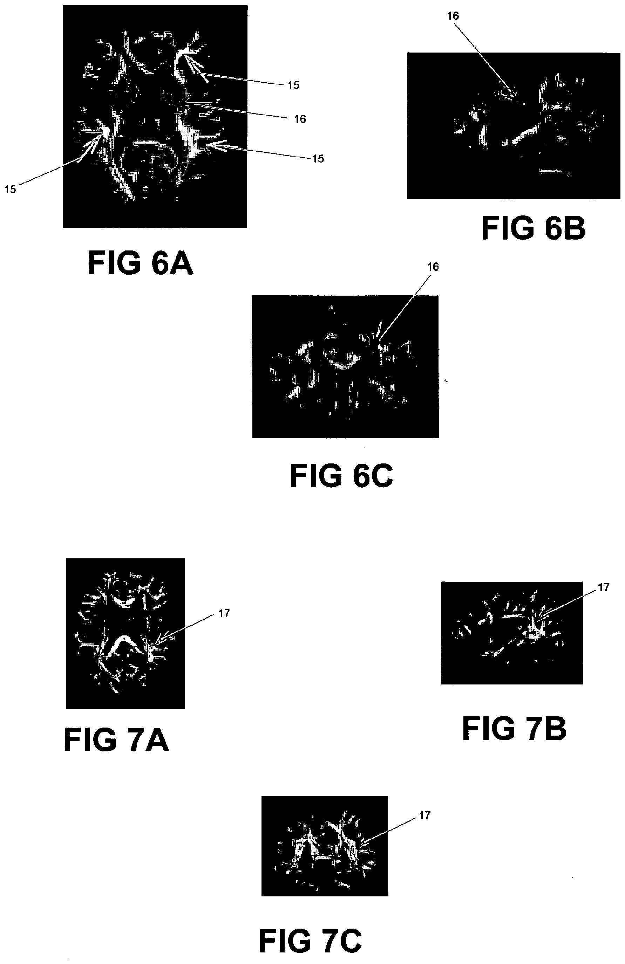

Images were obtained as described above, and processed so as to generate a probability density function for each voxel, and thereafter to generate a plurality of streamlines, as described above. Images obtained using these methods are shown in Figures 6A to 6C.

Figures 6A to 6C show a range of anatomical connectivity information which is available using the techniques described above. High intensity voxel values can be seen in tracts 15 connecting regions involved in language processing such as Wernicke's areas and left Broca's area. Much lower intensity voxel values are seen in the cortciospinal tracts (CSTs) 16. This is consistent with the extensive inter-regional connections within the language system and the relatively small number of connections from the motor regions to regions other than the brainstem, spinal cord, and thalamus.

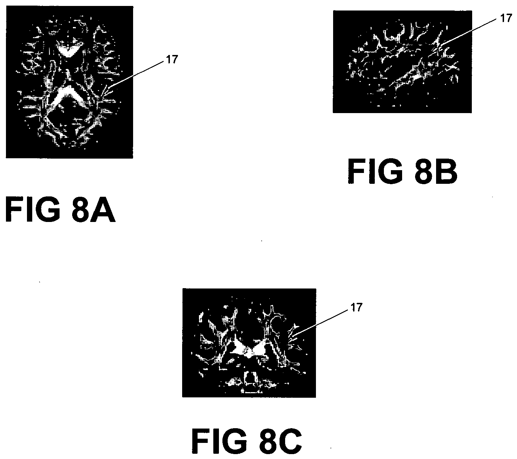

Figures 7A to 7C show three further images obtained using the techniques described above. Figures 8A to 8C show images generated using a known fractional anisotropy technique, which is generally assumed to identify white matter tracts (i.e. connecting pathways) within the brain. A fractional anisotropy technique is described in Pierpaoli, C. and P. J. Basser: "Toward a quantitative assessment of diffusion anisotropy" Magnetic Resonance in Medicine 36, pp893-906. It can be seen that areas 17 of high connectivity are not shown when the fractional anisotropy technique is used but are properly shown when the techniques described above are employed.

The techniques described above are advantageous in a number of respects. Specifically, given that the probabilistic tractography technique used to generate streamlines is initiated from each voxel (save for voxels representing cerebro-spinal fluid) there is no need to accurately locate a voxel from which the probabilistic tractography technique is to be initiated. This is a marked advantage over some prior art techniques which are intended to determine the connectivity of a particular voxel to other voxels and which therefore require accurate identification of the particular voxel.

It should be noted that the techniques described above allow connectivity between all brain regions to be effectively imaged, including regions representing white matter and regions representing grey matter.

The techniques described above provide information concerning the degree of cerebral anatomical interconnection to/from a given voxel position. As indicated above, relatively low intensity values can be seen in the CST. This is because although voxels representing the CST have high connectivity within the coherent structure of the corona radiata, they have low connectivity to the majority of other brain regions. Fractional anisotropy techniques do not provide information about how 'well-connected' voxels are. Conversely, the high, and lateralised, intensity values obtained in regions connecting language areas indicate the specificity of the method described above in distinguishing different degrees of 'connectedness'.

The techniques described above can be used for brain imaging in a variety of contexts. Typically, images generated using the techniques described above are compared with reference images to determine whether the imaged brain shows any abnormalities. The reference images may be generated from measurements taken from a plurality of subjects. As such, comparisons of this type are referred to herein as inter-subject comparisons. Images indicative of particular abnormalities may additionally or alternatively be stored and compared with obtained images. The techniques described have potential in studying pathologies such as, but not limited to, semantic dementia, MS, stroke, and schizophrenia, Alzheimer's disease, epilepsy and any pathology that may affect the degree of connection between brain regions.

The techniques described above can be used to compare a plurality of images taken from a single subject (intra-subject comparisons). For example a plurality of images can be generated from data taken from a single patient at different points in time over a period of time. The generated images can be compared with one another to detect any changes in connectivity within the subject. For example, effects caused by degenerative conditions can be detected in this way, as can effects caused by developmental problems.

It will be appreciated that intra-subject and inter-subject comparisons of the type described above require a degree of reproducibility in the measurements taken both from a single subject and from a number of different subjects. Reproducibility of the processing used in image generation is also required. Tests have shown that embodiments of the invention do indeed provide such reproducibility.

An investigation of the extent of differences between images generated from different sets of measurements taken from a single subject allow theoretical calculations on the sensitivity and hence group size required to detect differences between subject groups to be carried out. Differences between images generated from measurements taken from a single subject could be due to a combination of factors including measurement differences (including scanner noise, subject movements and subject positioning), differences in PDF generation, the probabilistic nature of the generation of streamlines and genuine physiological differences.

Reproducibility of the entire process from diffusion weighted MRI measurements to image generation as described above was assessed using the data from a plurality of subjects undergoing repeat scanning.

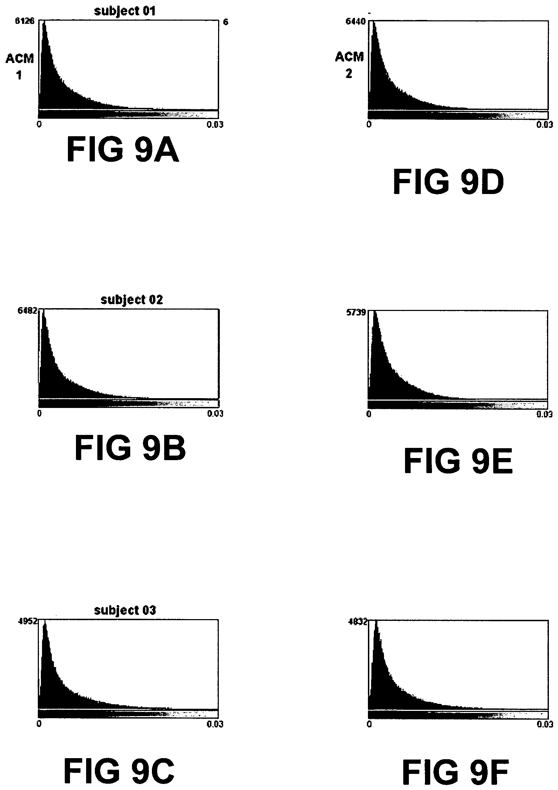

Figures 9A to 9F are histograms showing values of voxels in image data generated by the processing described above. Figures 9A and 9D show voxel values of two data sets generated from a first subject, Figures 9B and 9E show voxel values of two data sets generated from a second subject, while Figures 9C and 9F show voxel values of two data sets generated from a third subject.

These histograms of Figures 9A to 9F show a virtually identical shape both within and between subjects. The only substantial difference in the histograms of Figures 9A to 9F is a reduction on the Y axis in the histograms relating to the third subject as compared with the first and second subjects due to a smaller brain volume in the third subject.

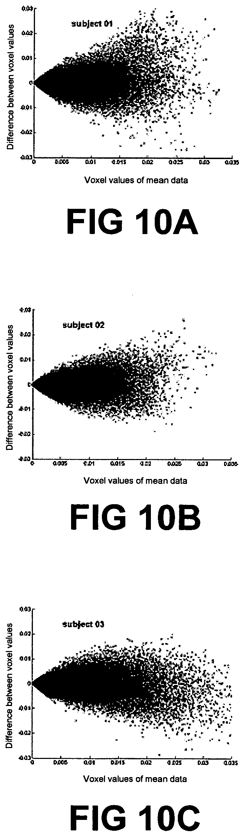

Bland-Altman plots of the difference between intra-subject data are shown in Figures 10A to 10C, where Figure 10A shows data related to the first subject, Figure 10B shows data related to the second subject and Figure 10C shows data related to the third subject. The use of Bland-Altman plots are described in Bland, M: "An Introduction to Medical Statistics", Oxford University Press, 1995. p272.

The Bland-Altman plots cluster around zero indicating that no overall bias was present between the intra-subject plots.

Measurements of intra-subject differences as a percentage of mean voxel value are shown in Table 1.

**TABLE 1**

| subject | difference as % of mean Methods described herein | | difference as % of mean Fractional Anisotropy | |
|---|---|---|---|---|
| | mean voxel level | SD voxel level | mean voxel level | SD voxel level |
| 01 | 32.852 | 24.241 | 15.088 | 14.257 |
| 02 | 31.354 | 23.444 | 17.324 | 15.648 |
| 03 | 29.577 | 22.407 | 13.916 | 15.326 |
| mean | 31.261 | 23.364 | 15.443 | 15.077 |

The values shown in Table 1 are the mean and standard-deviation (SD) of the differences, at the level of the individual voxel, for all voxels common to both data sets after registering to standard space. The equivalent statistics for fractional anisotropy data are also given for comparison.

The analysis set out above leads the present inventors to conclude that the techniques described herein can effectively be used to generate image data which is suitable for inter-subject and intra-subject comparison.

It has been described above with reference to Figure 1 that image data 2 is generated by the imaging device 1 and passed to the PC 3 for further processing. It will be appreciated that in alternative embodiments of the present invention, the PC 3 may be replaced by a bespoke device configured to implement the processing described above. Alternatively, the imaging device 1 may itself be configured to carry out the processing described above. Similarly, the display screen 4 may be incorporated into the imaging device 1.

Embodiments of the present invention have been described above in the context of brain imaging. It should be noted that embodiments of the invention are not restricted to brain imaging but are instead widely applicable, and could be applied to the imaging of a plurality of different objects. Specifically, in a biomedical context, the techniques can be used to generate images of any part of the central nervous system including a subject's spinal cord. Imaging of a subject's heart could also be carried out.

Although preferred embodiments of the invention generate diffusion orientation data for each voxel as described above using the Q-ball imaging method, other methods are used in alternative embodiments of the inventions. Such methods include PAS-MRI as described in Jansons, K. M. and D. C. Alexander: "Persistent angular structure: new insights from diffusion magnetic resonance imaging data" Inverse Problems 19, pp1031-1046; and Parker, G. J. M. and D. C. Alexander: "Probabilistic anatomical connectivity derived from the microscopic persistent angular structure of cerebral tissue" Philosophical Transactions of the Royal Society Series B 360, pp893-902, diffusion tensor MRI as described in Basser, P. J., J. Mattiello, et al.: "Estimation of the effective self-diffusion tensor from the NMR spin echo." Journal of Magnetic Resonance 103, pp247-254, tensor mixture models as described in Tuch, D. S., T. G. Reese, et al.: "High angular resolution diffusion imaging reveals intravoxel white matter fiber heterogeneity" Magnetic Resonance in Medicine 48, pp577-582; and Parker, G. J. M. and D. C. Alexander: "probabilistic Monte Carlo based mapping of cerebral connections utilising whole-brain crossing fibre information" Lecture Notes in Computer Science 2732, pp684-695, 'ball-and-stick' models as described in Behrens, T. E. J., M. W. Woolrich, et al.: "Characterization and propagation of uncertainty in diffusion-weighted MR imaging" Magnetic Resonance in Medicine 50(5), pp1077-1088, or spherical deconvolution methods as described in Tournier, J.-D., F. Calamante, et al.: "Direct estimation of the fiber orientation density function from diffusion-weighted MRI data using spherical deconvolution" NeuroImage 23, pp1176-1185.

In some cases the PDF for each voxel may become single-valued. In such a case each streamline generated from a given voxel is identical and only a single streamline is therefore required to be generated.

In an alternative embodiments the PDF for each voxel may describe multiple discrete fibre orientations rather than a continuum of possible orientations.

It should also be noted that while the generation of probability density functions has been described above based upon data transformed using a Funk-Radon transform, it will be appreciated that in other embodiments of the invention a Funk-Radon transform need not be used.

Although preferred embodiments of the present invention have been described above, it will be appreciated that various modifications can be made thereto without departing from the scope of the present invention, as defined by the appended claims.

**Claims**

1.   A computer-implemented method for generating data indicating a degree of anatomical connectivity for each of a plurality of three-dimensional image elements (10), each image element (10) representing a part of a human or animal body being imaged and being defined using data indicative of an orientation of diffusion of water within said body at a point represented by that image element, the method comprising:

for each of the plurality of image elements (10), generating a data set indicating anatomical connections between that image element (10) and others of said plurality of image elements (10), thus generating a plurality of data sets; for each of said plurality of image elements (10), generating data indicating a degree of anatomical connectivity of that image element (10), said degree of anatomical connectivity being based upon a total number of anatomical connections between the image element and others of said plurality of image elements in said plurality of generated data sets.

2.   A method according to claim 1, wherein each of said data sets represents a linear connection between one of said image elements (10) and a plurality of other image elements (10).

3.  A method according to claim 1 or 2, further comprising:

for each of said plurality of image elements (10), generating a plurality of data sets, each of said plurality of data sets being a data set indicating connections between that image element (10) and others of said plurality of image elements (10).

4.  A method according to claim 3, wherein each image element (10) has associated data indicating a plurality of possible connections for that image element (10), and said plurality of data sets are based upon said data.

5.  A method according to claim 4, wherein said associated data is a probability density function indicating probabilities of said possible connections.

6.  A method according to any preceding claim, wherein generating data indicating a degree of connectivity of a image element (10) comprises determining a number of data sets in which said image element (10) is included.

7.  A method according to any preceding claim, further comprising generating image data based upon said data indicating a degree of connectivity, wherein each image element (10) of said generated image data is rendered using a value based upon said data indicating a degree of connectivity relative to other image elements (10).

8.  A method according to claim 7, further comprising comparing said generated image data with further data generated from said body at an earlier time.

9.  A method according to any preceding claim, further comprising generating data indicating likelihood of diffusion of water in each of a plurality of directions at each image element, by:

generating a plurality of estimates of each of said plurality of directions of diffusion from said image data; and generating said data indicating likelihood of diffusion in each of said plurality of directions based upon said plurality of estimates;
wherein said plurality of generated data sets are generated based upon said data indicating likelihood of diffusion in each of a plurality of directions.

10. A method according to claim 9 wherein generating data indicating likelihood of diffusion in each of a plurality of directions further comprises:

processing said image data by application of a Funk-Radon transform to generate transformed image data; wherein said plurality of estimates of each of said plurality of directions of diffusion are generated from said transformed image data.

11. A method according to claim 9 or 10, wherein generating one of said plurality of estimates for each of said plurality of directions of diffusion comprises sampling an orientation distribution function at each of a plurality of points.

12. A method according to claim 11, wherein each of said plurality of points is located on the surface of a sphere.

13. A method according to claim 11 or 12, wherein some of said plurality of estimates for each of said plurality of directions are determined by;
generating a set comprising a plurality of points:

processing said set of points with reference to a further set of points to generate difference data; and generating a new set of points based upon said difference data.

14. A computer apparatus for generating data indicating a degree of anatomical connectivity for each of a plurality of three-dimensional image elements (10), each image element (10) representing a part of a human or animal body being imaged, and being defined using data indicative of an orientation of diffusion of water within said body at a point represented by that image element, the apparatus comprising:

a memory storing processor readable instructions; and

a processor configured to read and execute instructions stored in said memory;
wherein said processor readable instructions comprise instructions controlling said processor to carry out a method according to any preceding claim.

**Patentansprüche**

1. Computerimplementiertes Verfahren zum Generieren von Daten, die einen Grad an anatomischer Vernetzung für jedes einer Vielzahl von dreidimensionalen Bildelementen (10) anzeigen, wobei jedes Bildelement (10) einen Teil eines menschlichen oder tierischen Körpers darstellt, der abgebildet wird und unter Verwendung von Daten definiert ist, die eine Ausrichtung einer Diffusion von Wasser in dem Körper an einem Punkt anzeigen, der durch das Bildelement dargestellt wird, wobei das Verfahren Folgendes umfasst:

   Generieren eines Datensatzes für jedes der Vielzahl von Bildelementen (10), der anatomische Vernetzungen zwischen diesem Bildelement (10) und anderen der Vielzahl von Bildelementen (10) anzeigt, wodurch eine Vielzahl von Datensätzen generiert werden;
   Generieren von Daten für jedes der Vielzahl von Bildelementen (10), die einen Grad an anatomischer Vernetzung dieses Bildelements (10) anzeigen, wobei der Grad an anatomischer Vernetzung auf einer Gesamtanzahl von anatomischen Verbindungen zwischen dem Bildelement und anderen der Vielzahl von Bildelementen in der Vielzahl von generierten Datensätzen basiert.

2. Verfahren nach Anspruch 1, wobei jeder der Datensätze eine lineare Verbindung zwischen einem der Bildelemente (10) und einer Vielzahl von anderen Bildelementen (10) darstellt.

3. Verfahren nach Anspruch 1 oder 2, ferner umfassend:

   das Generieren von einer Vielzahl von Datensätzen für jedes der Vielzahl von Bildelementen (10), wobei es sich bei jedem der Vielzahl von Datensätzen um einen Datensatz handelt, der Verbindungen zwischen dem Bildelement (10) und anderen der Vielzahl von Bildelementen (10) anzeigt.

4. Verfahren nach Anspruch 3, wobei jedes Bildelement (10) zugeordnete Daten aufweist, die eine Vielzahl von möglichen Verbindungen für dieses Bildelement (10) anzeigen, und die Vielzahl von Datensätzen auf den Daten basieren.

5. Verfahren nach Anspruch 4, wobei es sich bei den zugeordneten Daten um eine Wahrscheinlichkeitsdichtefunktion handelt, die Wahrscheinlichkeiten der möglichen Verbindung anzeigt.

6. Verfahren nach einem der vorhergehenden Ansprüche, wobei das Generieren von Daten, die einen Grad an Vernetzung eines Bildelements (10) anzeigen, das Bestimmen einer Anzahl von Datensätzen umfasst, in denen das Bildelement (10) eingeschlossen ist.

7. Verfahren nach einem der vorhergehenden Ansprüche, ferner umfassend das Generieren von Bilddaten auf Grundlage der Daten, die einen Grad an Vernetzung anzeigen, wobei jedes Bildelement (10) der generierten Bilddaten unter Verwendung eines Werts gerendert wird, der auf den Daten basiert, die einen Grad von Vernetzung bezogen auf anderen Bilddaten (10) anzeigen.

8. Verfahren nach Anspruch 7, ferner umfassend das Vergleichen der generierten Bilddaten mit weiteren Daten, die zu einem früheren Zeitpunkt von dem Körper generiert wurden.

9. Verfahren nach einem der vorhergehenden Ansprüche, ferner umfassend das Generieren von Daten, die eine Wahrscheinlichkeit einer Diffusion von Wasser in jeder einer Vielzahl von Richtung an jedem Bildelement anzeigen, durch Folgendes:

   Generieren einer Vielzahl von Schätzungen von jeder der Vielzahl von Diffusionsrichtungen aus den Bilddaten; und
   Generieren der Daten, die eine Wahrscheinlichkeit einer Diffusion in jeder der Vielzahl von Richtungen anzeigen, auf Grundlage der Vielzahl von Schätzungen;
   wobei die Vielzahl von generierten Datensätzen auf Grundlage der Daten generiert werden, die eine Wahrscheinlichkeit einer Diffusion in jeder einer Vielzahl von Richtungen anzeigen.

**10.** Verfahren nach Anspruch 9, wobei das Generieren von Daten, die eine Wahrscheinlichkeit einer Diffusion in jeder von einer Vielzahl von Richtungen anzeigen, ferner Folgendes umfasst:

Verarbeiten der Bilddaten, durch das Anwenden einer Funk-Radon-Transformation, um transformierte Bilddaten zu generieren;
wobei die Vielzahl von Schätzungen von jeder der Vielzahl von Diffusionsrichtungen aus den transformierten Bilddaten generiert wird.

**11.** Verfahren nach Anspruch 9 oder 10, wobei das Generieren von einer der Vielzahl von Schätzungen für jede von der Vielzahl von Diffusionsrichtungen Probenehmen einer Ausrichtungsverteilungsfunktion an jeder der Vielzahl von Punkten umfasst.

**12.** Verfahren nach Anspruch 11, wobei sich jeder der Vielzahl von Punkten auf der Oberfläche einer Kugel befindet.

**13.** Verfahren nach Anspruch 11 oder 12, wobei einige der Vielzahl von Schätzungen für jede der Vielzahl von Richtungen durch Folgendes bestimmt werden:

Generieren eines Satzes, der eine Vielzahl von Punkten umfasst;
Verarbeiten des Punktesatzes in Bezug auf einen weiteren Satz von Punkten, um Differenzdaten zu generieren; und
Generieren eines neuen Satzes von Punkten auf Grundlage der Differenzdaten.

**14.** Computervorrichtung zum Generieren von Daten, die einen Grad an anatomischer Vernetzung für jedes einer Vielzahl von dreidimensionalen Bildelementen (10) anzeigen, wobei jedes Bildelement (10) einen Teil eines menschlichen oder tierischen Körpers darstellt, der abgebildet wird und der unter Verwendung von Daten definiert ist, die eine Ausrichtung einer Diffusion von Wasser in dem Körper an einem Punkt anzeigen, der durch das Bildelement dargestellt wird, wobei die Vorrichtung Folgendes umfasst:

einen Speicher, der prozessorlesbare Anweisungen speichert; und
einen Prozessor, der konfiguriert ist, um die in dem Speicher gespeicherten Anweisungen zu lesen und auszuführen;
wobei die prozessorlesbaren Anweisungen Anweisungen umfassen, die den Prozessor steuern, um ein Verfahren nach einem der vorhergehenden Ansprüche auszuführen.

**Revendications**

**1.** Procédé mis en oeuvre par un ordinateur, permettant de générer des données indiquant un degré de connectivité anatomique pour chaque élément parmi une pluralité d'éléments d'image tridimensionnels (10), chaque élément d'image (10) représentant une partie d'un corps humain ou animal en cours d'imagerie et étant défini à l'aide des données indicatives d'une orientation de diffusion d'eau au sein dudit corps au niveau d'un point représenté par ledit élément d'image,
le procédé comprenant les étapes consistant à :

pour chaque élément parmi la pluralité d'éléments d'image (10), générer un ensemble de données indiquant des connexions anatomiques entre ledit élément d'image (10) et d'autres éléments parmi ladite pluralité d'éléments d'image (10), ce qui génère une pluralité d'ensembles de données ;
pour chaque élément parmi ladite pluralité d'éléments d'image (10), générer des données indiquant un degré de connectivité anatomique dudit élément d'image (10), ledit degré de connectivité anatomique étant basé sur un nombre total de connexions anatomiques entre l'élément d'image et d'autres éléments parmi ladite pluralité d'éléments d'image au sein de ladite pluralité d'ensembles de données générés.

**2.** Procédé selon la revendication 1, dans lequel chaque ensemble parmi lesdits ensembles de données représente une connexion linéaire entre un desdits éléments d'image (10) et une pluralité d'autres éléments d'image (10).

**3.** Procédé selon la revendication 1 ou 2, comprenant en outre l'étape consistant à :

pour chaque élément parmi ladite pluralité d'éléments d'image (10), générer une pluralité d'ensembles de données, chaque ensemble parmi ladite pluralité d'ensembles de données étant un ensemble de données indiquant des connexions entre ledit élément d'image (10) et d'autres éléments parmi ladite pluralité d'éléments d'image (10).

4.   Procédé selon la revendication 3, dans lequel chaque élément d'image (10) présente des données associées indiquant une pluralité de connexions possibles pour ledit élément d'image (10), et ladite pluralité d'ensembles de données sont basés sur lesdites données.

5.   Procédé selon la revendication 4, dans lequel lesdites données associées correspondent à une fonction de densité de probabilité indiquant des probabilités desdites connexions possibles.

6.   Procédé selon l'une quelconque des revendications précédentes, dans lequel l'étape de génération de données indiquant un degré de connectivité d'un élément d'image (10) comprend une étape consistant à déterminer un nombre d'ensembles de données au sein desquels est inclus ledit élément d'image (10).

7.   Procédé selon l'une quelconque des revendications précédentes, comprenant en outre une étape consistant à générer des données d'image en se basant sur lesdites données indiquant un degré de connectivité, dans lequel chaque élément d'image (10) desdites données d'image générées est restitué à l'aide d'une valeur basée sur lesdites données indiquant un degré de connectivité par rapport à d'autres éléments d'image (10).

8.   Procédé selon la revendication 7, comprenant en outre une étape consistant à comparer lesdites données d'image générées avec d'autres données générées par ledit corps à un instant antérieur.

9.   Procédé selon l'une quelconque des revendications précédentes, comprenant en outre une étape consistant à générer des données indiquant une probabilité de diffusion d'eau dans chaque direction parmi une pluralité de directions au niveau de chaque élément d'image, grâce aux étapes consistant à :

   générer une pluralité d'estimations de chaque direction parmi ladite pluralité de directions de diffusion à partir desdites données d'image ; et
   générer lesdites données indiquant une probabilité de diffusion dans chaque direction parmi ladite pluralité de directions en se basant sur ladite pluralité d'estimations ;
   dans lequel ladite pluralité d'ensembles de données générés sont générés en se basant sur lesdites données indiquant une probabilité de diffusion dans chaque direction parmi une pluralité de directions.

10.  Procédé selon la revendication 9, dans lequel l'étape de génération de données indiquant une probabilité de diffusion dans chaque direction parmi une pluralité de directions comprend en outre l'étape consistant à :

   traiter lesdites données d'image par application d'une transformée de Funk-Radon afin de générer des données d'image transformées ;
   dans lequel ladite pluralité d'estimations de chaque direction parmi ladite pluralité de directions de diffusion sont générées à partir desdites données d'image transformées.

11.  Procédé selon les revendications 9 ou 10, dans lequel l'étape de génération d'une estimation parmi ladite pluralité d'estimations pour chaque direction parmi ladite pluralité de directions de diffusion comprend une étape consistant à échantillonner une fonction de distribution d'orientation au niveau de chaque point parmi une pluralité de points.

12.  Procédé selon la revendication 11, dans lequel chaque point parmi ladite pluralité de points est situé sur la surface d'une sphère.

13.  Procédé selon la revendication 11 ou 12, dans lequel certaines estimations parmi ladite pluralité d'estimations pour chaque direction parmi ladite pluralité de directions sont déterminées grâce aux étapes consistant à :

   générer un ensemble comprenant une pluralité de points ;
   traiter ledit ensemble de points en se référant à un autre ensemble de points afin de générer des données de différence ; et
   générer un nouvel ensemble de points en se basant sur lesdites données de différence.

14.  Appareil informatique permettant de générer des données indiquant un degré de connectivité anatomique pour chaque élément d'image parmi une pluralité d'éléments d'image tridimensionnels (10), chaque élément d'image (10) représentant une partie d'un corps humain ou animal en cours d'imagerie, et étant défini à l'aide de données indicatives d'une orientation de diffusion d'eau au sein dudit corps au niveau d'un point représenté par ledit élément d'image, ledit appareil comprenant :

une mémoire stockant des instructions pouvant être lues par un processeur ; et
un processeur configuré pour lire et exécuter des instructions stockées dans ladite mémoire ;
dans lequel lesdites instructions pouvant être lues par un processeur comprennent des instructions commandant ledit processeur afin de mettre en oeuvre un procédé selon l'une quelconque des revendications précédentes.

FIG 1

FIG 2

**FIG 3**

```
                                    ╭─────────╮
                                    │  FIG 2  │
                                    │ STEP S4 │
                                    ╰────╲───╱─╯
                                         │
    ┌────────────────────────────────────┤
    │                                    │  S12
    │                            ┌────────▼────────┐
    │                            │                 │
    │                            │  SELECT VOXEL   │
    │                            │                 │
    │                            └────────┬────────┘
    │                                     │  S13
    │                            ┌────────▼────────┐
    │                            │                 │
    │                            │   STORE VOXEL   │
    │                            │                 │
    │                            └────────┬────────┘
    │                                     │  S14
    │                            ┌────────▼────────┐
    │                            │                 │
    │                            │   SAMPLE PDF    │
    │                            │                 │
    │                            └────────┬────────┘
    │                                     │  S15
    │                            ┌────────▼────────┐
    │                            │    DETERMINE    │
    │                            │   NEXT VOXEL    │
    │                            │                 │
    │                            └────────┬────────┘
    │                                     │  S16
    │    NO                          ◇ END? ◇
    └────────────────────────────────────┤
                                         │ YES
                                         │  S17
                                ┌────────▼────────┐
                                │     STORE       │
                                │   STREAMLINE    │
                                └────────┬────────┘
                                         │  S18
    S19                            ◇ MORE        ◇
┌──────────────┐   YES        STREAMLINES FOR
│  SET START   │◄─────────────   STARTING
└──────────────┘                   VOXEL
                                         │ NO
                                         │  S20
                                    ╭────▼────╮
                                    │  FIG 2  │
                                    │ STEP S2 │
                                    ╰─────────╯
```

# FIG 4

S22

GENERATE ODF

S23

THRESHOLD SAMPLES TO DETERMINE SIGNAL/NOISE

S24

FIT LINEAR FUNCTION TO SIGNAL SAMPLES

S25

ANALYSE OF NUMBER N OF LOCAL MAXIMA

S26

n>3?

YES

S27

FIT n DIFFUSION TENSORS

S28

VOXEL IS ISOTROPIC

S29

DETERMINE RESIDUAL VALUES

S28a

GENERATE RANDOM ORIENTATION INFORMATION

S30

GENERATE BOOSTRAP DATA

S31

GENERATE PDF

**FIG 5A**

FIG 5B

**FIG 6A**

**FIG 6B**

**FIG 6C**

**FIG 7A**

**FIG 7B**

**FIG 7C**

FIG 8A

FIG 8B

FIG 8C

subject 01

ACM
1

8126

6

0

0.03

# FIG 9A

6440

ACM
2

0

0.03

# FIG 9D

subject 02

6482

0

0.03

# FIG 9B

5739

0

0.03

# FIG 9E

subject 03

4952

0

0.03

# FIG 9C

4832

0

0.03

# FIG 9F

Voxel values of mean data

# FIG 10A

Voxel values of mean data

# FIG 10B

Voxel values of mean data

# FIG 10C

## REFERENCES CITED IN THE DESCRIPTION

**Non-patent literature cited in the description**

- **PIERPAOLI, C. ; P. J. BASSER.** Toward a quantitative assessment of diffusion anisotropy. *Magnetic Resonance in Medicine,* vol. 36, 893-906
- **PARKER, G.J.M ; ALEXANDER, D.C.** Probabilistic anatomical connectivity derived from the microscopic persistent angular structure of cerebral tissue. *Phil. Trans. R. Soc. B,* 2005, vol. 360, 893-902
- **PARKER, G. J. M. ; H. A. HAROON et al.** A framework for a streamline-based probabilistic index of connectivity (PICo) using a structural interpretation of MRI diffusion measurements. *Journal of Magnetic Resonance Imaging,* vol. 18, 242-254
- **MORI, S. ; B. J. CRAIN et al.** Three-dimensional tracking of axonal projections in the brain by magnetic resonance imaging. *Annals of Neurology,* vol. 45, 265-269
- **BEHRENS, T. E. J. ; M. W. WOOLRICH et al.** Characterization and propagation of uncertainty in diffusion-weighted MR imaging. *Magnetic Resonance in Medicine,* vol. 50 (5), 1077-1088
- **BASSER, P. J. ; S. PAJEVIC et al.** In vivo fiber tractography using DT-MRI data. *Magnetic Resonance in Medicine,* vol. 44, 625-632
- **PARKER, G. J. M. ; D. C. ALEXANDER.** Probabilistic Monte Carlo based mapping of cerebral connections utilising whole-brain crossing fibre information. *Lecture Notes in Computer Science,* vol. 2732, 684-695
- **HOSEY, T., G. WILLIAMS et al.** Inference of multiple fiber orientations in high angular resolution diffusion imaging. *Magnetic Resonance in Medicine,* vol. 54, 1480-1489
- **PARKER, G. J. M. ; D. C. ALEXANDER.** Probabilistic anatomical connectivity derived from the microscopic persistent angular structure of cerebral tissue. *Philosophical Transactions of the Royal Society Series B,* vol. 360, 893-902
- Study of connectivity in the brain using the full diffusion tensor from MRI. **BATCHELOR, P. G. ; D. L. G. HILL et al.** Proceedings of Information Processing in Medical Imaging IPMI'01. Springer-Verlag
- **KOCH, M. ; V. GLAUCHE et al.** Estimation of anatomical connectivity from diffusion tensor data. *Neuroimage,* vol. 13 (6), S176-S176
- **KOCH, M. A. ; D. G. NORRIS et al.** An investigation of functional and anatomical connectivity using magnetic resonance imaging. *Neuroimage,* vol. 16, 241-250
- **PARKER, G. J. M. ; C. A. M. WHEELER-KINGSHOTT et al.** Estimating distributed anatomical brain connectivity using fast marching methods and diffusion tensor imaging. *IEEE Transactions on Medical Imaging,* vol. 21 (5), 505-512
- **TOURNIER, J.-D. ; F. CALAMANTE et al.** Diffusion-weighted magnetic resonance imaging fibre tracking using a front evolution algorithm. *NeuroImage,* vol. 20, 276-288
- **TUCH, DAVID S.** Q-Ball Imaging. *Magnetic Resonance in Medicine,* 2004, vol. 52, 1358-1372
- **TUCH, D. S. ; T. G. REESE et al.** High angular resolution diffusion imaging reveals intravoxel white matter fiber heterogeneity. *Magnetic Resonance in Medicine,* vol. 48, 577-582
- **EMBLETON K.V. ; LAMBON RALPH M.A. ; PARKER G. J.** A combined distortion corrected protocol for Diffusion Weighted Tractography and fMRI. *ISMRM,* 2006, 1070
- **BLAND, M.** An Introduction to Medical Statistics. Oxford University Press, 1995, 272
- **JANSONS, K. M. ; D. C. ALEXANDER.** Persistent angular structure: new insights from diffusion magnetic resonance imaging data. *Inverse Problems,* vol. 19, 1031-1046
- **BASSER, P. J. ; J. MATTIELLO et al.** Estimation of the effective self-diffusion tensor from the NMR spin echo. *Journal of Magnetic Resonance,* vol. 103, 247-254
- **PARKER, G. J. M. ; D. C. ALEXANDER.** probabilistic Monte Carlo based mapping of cerebral connections utilising whole-brain crossing fibre information. *Lecture Notes in Computer Science,* vol. 2732, 684-695
- **TOURNIER, J.-D. ; F. CALAMANTE et al.** Direct estimation of the fiber orientation density function from diffusion-weighted MRI data using spherical deconvolution. *NeuroImage,* vol. 23, 1176-1185